# EUROPEAN PATENT APPLICATION

(11) **EP 4 491 759 A1**
(43) Date of publication of application: **15.01.2025**
(21) Application number: 24181019.1
(22) Date of filing: 10.06.2024
(51) Int. Cl.: C23C 16/32, C23C 16/44, C23C 16/455, C23C 16/46, C23C 16/458

(54) **APPARATUS FOR MANUFACTURING SEMICONDUCTOR DEVICES**

(30) Priority: 13.06.2023 IT 202300012138
(71) Applicant: LPE S.p.A., 20021 Baranzate (MI) (IT)
(72) Inventor: COREA, Francesco, Bollate (MI) (IT); POLLI, Stefano, 20021 Baranzate (MI) (IT); PRETI, Silvio Roberto Mario, 20021 Baranzate (MI) (IT); CRIPPA, Danilo, 20021 Baranzate (MI) (IT); BERGE, Rune, Lund (SE); VALENTE, Gianluca, Milano (IT)
(74) Representative: Buzzi, Notaro & Antonielli d'Oulx S.p.A.

(57) **Abstract**

Apparatus (10) for manufacturing semiconductor devices of the type comprising a substrate (101) and a film applied onto the substrate by means of a chemical-vapor-deposition (CVD) process, comprising:
- a process chamber (2) in which to arrange substrates (101) in a linear formation (101') along a first reference axis (Z) of the process chamber (2) and according to an orientation in which the substrates (101) lie in parallel planes orthogonal to the first reference axis (Z);
- a heating system for heating the process chamber (2) to a predetermined inner temperature;
- a delivering unit (4) for delivering a process gas to the process chamber (2),
wherein in the process chamber (2) the process gas undergoes a CVD process to form a film on each substrate (101) of the linear formation;
- an exhaust gas extraction unit (6) for extracting a process exhaust gas from the process chamber (2);

The apparatus comprises a case (8) enclosing the process chamber (2), which is configured to be traversed by a gas flow that moves along a second reference axis (Y) transversal to the first reference axis (Z) and across the substrates linear formation (101') arranged in the process chamber (2).

## Description

### Technical field of the invention

The present invention relates to an apparatus for manufacturing semiconductor devices of the type comprising a substrate and a film applied onto the substrate by means of a chemical-vapor-deposition (CVD) process.

An apparatus of this type comprises a process chamber in which to arrange a plurality of substrates and in which a process gas supplied to the process chamber undergoes a CVD process to form a film on the plurality of substrates.

An aspect of the manufacturing process implemented by such an apparatus may be that the CVD process should lead to the formation of substantially identical films (e.g., having substantially the same thickness) on every substrate arranged in the process chamber.

This may be achieved when, in the process chamber, homogenous conditions such as temperature, gas flow rate and pressure may be established for all the positions occupied by the plurality of substrates.

JP2014123616A, JP5783859B2 and JP2550024B2 disclose certain prior art apparatuses.

### Summary of the invention

The present invention proposes an apparatus for manufacturing semiconductor devices

The present invention relates in a general way to an apparatus according to Claim 1.
The present invention also relates to a method according to Claim 20.

The claims form an integral part of the teachings provided here.

### Brief description of the drawings and detailed description of one or more embodiments of the invention

Further characteristics and advantages of the invention will be apparent from the following description, which refers to the attached drawings provided purely by way of non-limiting example, in which:
- Figure 1 shows a preferred embodiment of the apparatus described here;
- Figure 2 shows an inner housing of the apparatus of Figure 1;
- Figure 3 shows the apparatus of Figure 1 sectioned in different parts so as to show its inner regions;
- Figure 4 shows a case of the apparatus of Figure 1;
- Figure 5 shows the case of Figure 4 partially disassembled;
- Figure 6 shows a substrates linear formation on which to deposit a film by a CVD process implemented in the apparatus of figure 1;
- Figures 7 and 7A show a delivering unit of the apparatus of Figure 1 in an assembled condition and in a disassembled condition, respectively;
- Figure 7B is a side view of the delivering unit of Figure 7 and Figure 7C shows a cross section of the delivering unit in plane I-I shown in Figure 7B;
- Figures 8 and 8A show an exhaust gas extraction unit of the apparatus of Figure 1 in an assembled condition and in a disassembled condition, respectively;
   - - Figure 8B is a side view of the exhaust gas extraction unit of Figure 8 and Figure 8C shows a cross section of the exhaust gas extraction unit in plane II-II shown in Figure 8B;
- Figure 9 is a schematic representation of the apparatus of Figure 1.

The following description illustrates various specific details intended to provide a deeper understanding of the embodiments. The embodiments may be realized without one or more of the specific details, or with other methods, components or materials, etc. In other cases, known structures, materials or operations are not shown or described in detail, to avoid obscuring various aspects of the embodiment.

The references used here are purely for convenience and therefore do not define the scope of protection or the extent of the embodiments.

As mentioned above, the apparatus described here is an apparatus for manufacturing semiconductor devices of the type comprising a substrate and a film applied (e.g., deposited) onto the substrate by means of a chemical-vapor-deposition (CVD) process or a low pressure chemical vapor deposition (LPCVD) process. For instance, the deposited film may comprise or consist of silicon carbide.

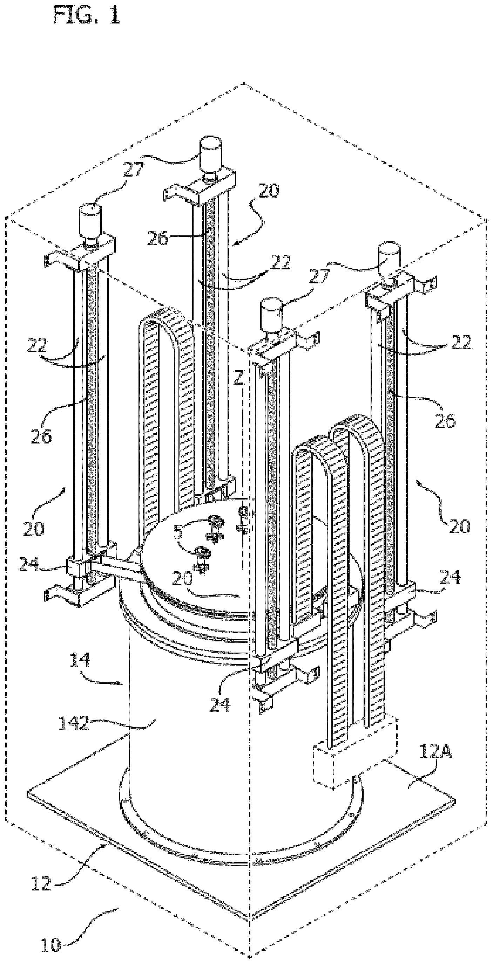

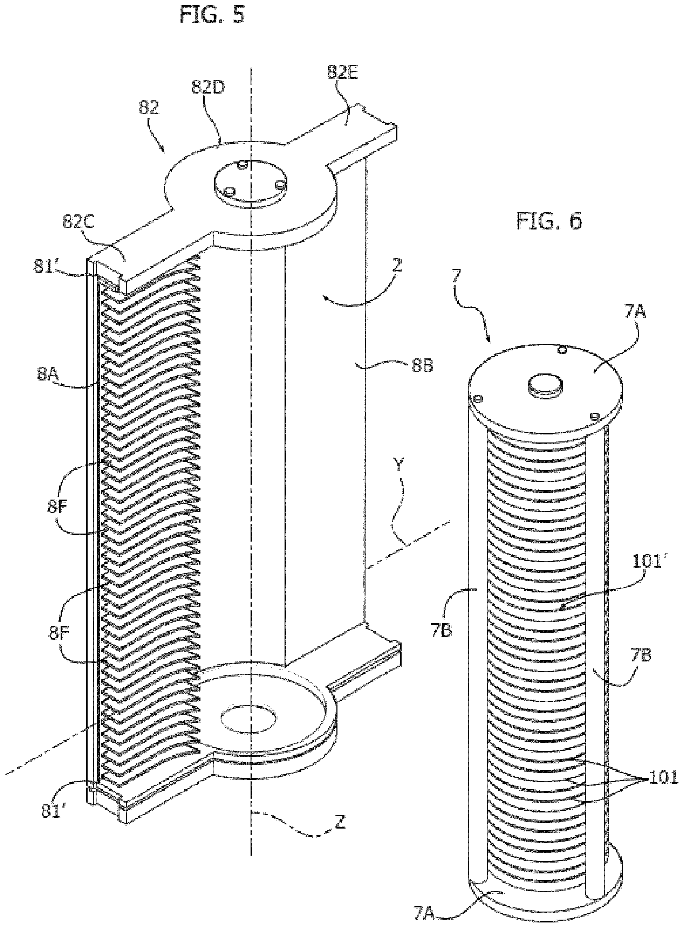

With reference to the figures 1 to 8, the apparatus - which is indicated as a whole by the reference numeral 10 - comprises:
- a process chamber 2, in which to arrange substrates 101 (e.g., silicon or graphite wafers) that are to undergo the CVD process;
- a delivering unit 4 for delivering a process gas to the process chamber, and
- an exhaust gas extraction unit 6 for extracting a process exhaust gas from the process chamber.

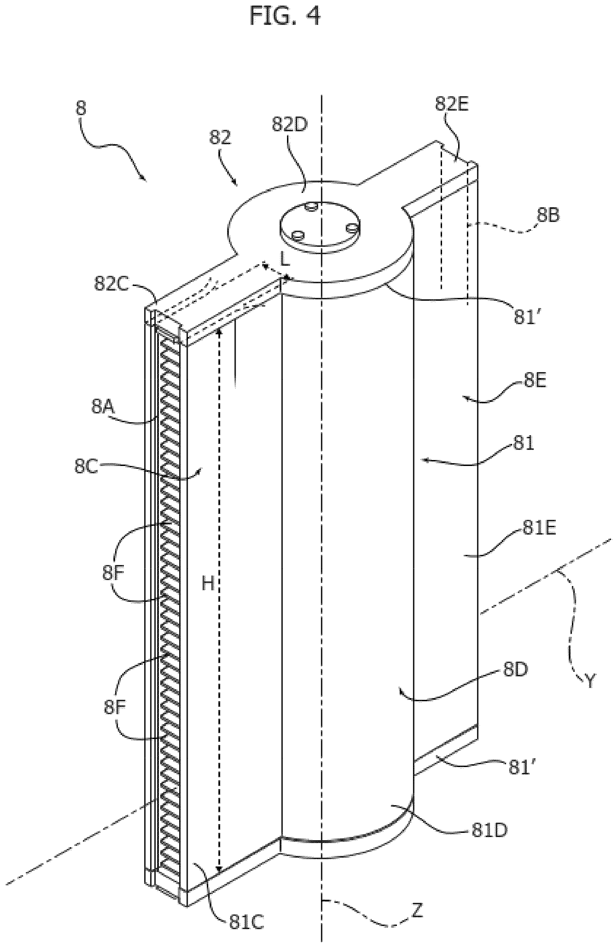

In one or more preferred embodiments, such as the one illustrated (see figures 4 to 6), the apparatus 10 comprises a case 8 enclosing the process chamber 2 and having an inlet 8A receiving the process gas ejected by the delivering unit 4, and an outlet 8B directing the process exhaust gas towards the exhaust gas extraction unit 6.

In one or more preferred embodiments, such as the one illustrated, the case 8 comprises an inlet section 8C, a central section 8D and an outlet section 8E, which are arranged in succession along a reference axis Y.

The central section 8D encloses the process chamber 2. On the other hand, the inlet section 8C includes the inlet 8A, and the outlet section 8E includes the outlet 8B; the inlet 8A and the outlet 8B are both in fluid communication with the process chamber 2 enclosed by the central section 8D.

The central section 8D is configured to receive a plurality of substrates 101 arranged in a linear formation 101' along a reference axis Z orthogonal to the reference axis Y and according to an orientation in which the substrates 101 lie in parallel planes orthogonal to the reference axis Z.

In one or more preferred embodiments, such as the one illustrated, the reference axis Z is vertical, whereas the reference axis Y is horizontal.

In an alternative embodiment, the reference axis Z is horizontal and the reference axis Y is vertical. In a further alternative embodiment, both reference axes Z and Y are horizontal.

The substrates 101 are preferably loaded on a rack 7 (or any other equivalent frame) that is configured to hold and support the substrates according to the above cited linear formation 101'.

In the illustrated example, the rack 7 comprises two opposite disk-shaped ends 7A connected together by three longitudinal posts 7B positioned on the peripheral edges of the two ends 7A at a constant reciprocal angular distance of 120°.

The posts 7B have respective longitudinal series of internally-projecting pins (not visible) which are to support the substrates 101 on parallel lying planes according to the arrangement of the linear formation 101'.

Preferably, the rack 7 is fitted with a rotation mechanism (not illustrated) for making the rack 7 and the substrates 101, carried thereby, rotate about an axis of rotation parallel to the reference axis Z, during the CVD process.

The case 8 is configured to build a pressure differential between the inlet 8A and the outlet 8B generating a gas flow traversing the case 8 from the inlet 8A to the outlet 8B. In particular, the generated gas flow moves along the reference axis Y passing through, in series, the inlet section 8C, the central section 8D and the outlet section 8E; in the central section 8D, the gas flow passes across the substrates linear formation 101' and flows over all the substrates 101.

In one or more preferred embodiments, such as the one illustrated, the case 8 has a cross-sectional flow area whose dimension H along the reference axis Z is uniform and constant all across the inlet, central and outlet sections 8C, 8D, 8E.

On the other hand, in one or more preferred embodiments, such as the one illustrated, the cross-sectional flow area of the case 8 has a dimension L, in the direction orthogonal to the reference axis Z, that is enlarged at the central section 8D with respect to the inlet and outlet sections 8C, 8E; as a result of this feature, the gas flow velocity in the central section 8D is lower than in the inlet and outlet sections 8C, 8E.

The case 8 is preferably made of a material that is both heat conductive and resistant to high temperatures; incidentally, it is noted that by "high temperatures" it is meant temperatures higher than 1000°C and up to 1400°C, which represents the range of temperatures normally required in a process chamber during a CVD process. Preferably, the case 8 is made of graphite.

In view of the above, the case 8 is configured as a shaped duct that encloses the process chamber 2 and creates a fluid dynamic system controlling the supply of the process gas to the process chamber 2 and the removal of the process exhaust gas from the same process chamber.

In one or more preferred embodiments, such as the one illustrated, the inlet section 8C contains a series of fins 8F extending in a linear formation parallel to the reference axis Z and facing the inlet 8A; each fin 8F lies orthogonally to the reference axis Z and all the fins 8F are equally-spaced and positioned along the axis Z so as to uniformly distribute and guide the gas flow entering the case inlet 8A to multiple positions corresponding to the positions of the substrates 101 in the linear formation 101'. Preferably, the fins 8F are made of graphite.

From the constructional point of view, the case 8 can be realized in different ways according to the needs of the specific applications.

In one or more preferred embodiments, such as the one illustrated, the case 8 comprises a pair of opposed walls 81 both generally extending along the reference axis Y and a pair of end closures 82 which are mounted to edges 81' of the pair of walls 81 that are opposite to one another along the reference axis Z.

Referring to the reference axis Y, each one of the pair of opposed walls 81 has an upstream-end flat portion 81C, a downstream-end flat portion 81E and a central, concave (e.g., cylindrical) portion 81D with a convex side facing to the outside of the case 8.

Analogously, with reference to the reference axis Y, each one of the pair of end closures 82 has an upstream-end flat portion 82C, a downstream-end flat portion 82E, and a central flat portion 82D.

The pair of walls 81 and the pair of end closures 82 are assembled together to form the case 8, particularly in such a manner that:
- the upstream-end flat portions 81C of the pair of opposed walls 81 and the upstream-end flat portions 82C of the pair of end closures 82 form together the inlet section 8C of the case 8;
- the central portions 81D of the pair of opposed walls 81 and the central portions 82D of the pair of end closures 82 form together the central section 8D of the case 8; and
- the downstream-end flat portions 81E of the pair of opposed walls 81 and the downstream-end flat portions 82E of the pair of end closures 82 form together the outlet section 8E of the case 8.

Furthermore, the apparatus 10 comprises a heating system for heating the process chamber 2 to a predetermined inner temperature, which will normally be within the range of temperatures from 1000°C to 1400°C indicated above.

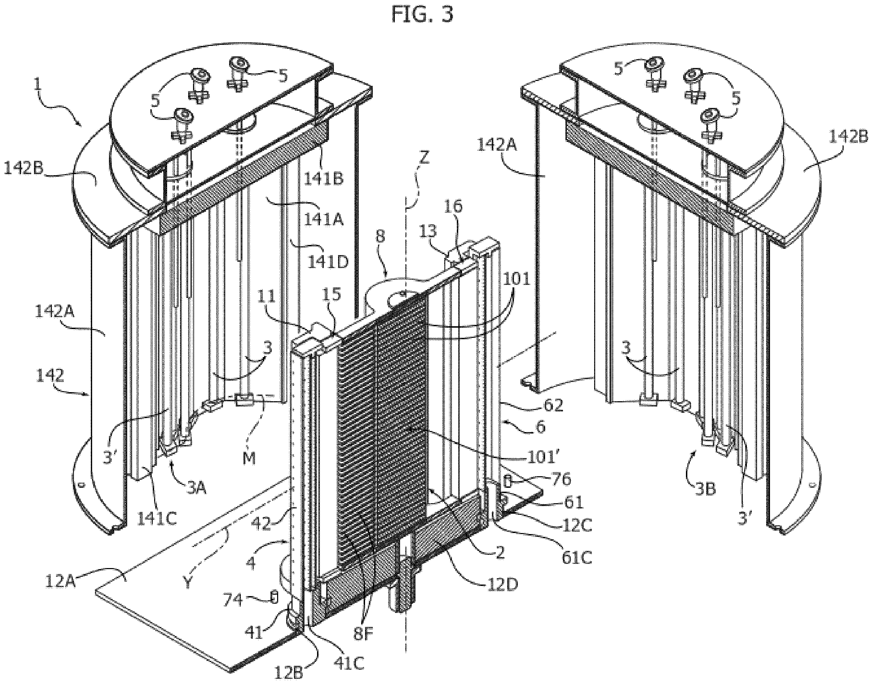

In one or more preferred embodiments, such as the one illustrated (see figure 3), the heating system comprises a plurality of heaters 3 which are positioned outside of the case 8 and are to generate heat radiation to heat up the case 8.

The radiantly-heated case 8 constitutes a "hot wall" which, on its turn, heats the process chamber 2 and the substrates contained in it to the predetermined inner temperature.

In one or more preferred embodiments, such as the one illustrated, the heaters 3 longitudinally extend parallel to the reference axis Z and for a length substantially equal to the dimension (i.e., the height in the illustrated example) of the case 8 along the same axis Z.

In one or more preferred embodiments, such as the one illustrated, the heating system comprises two series 3A, 3B of the heat-radiating heaters 3 which are arranged outside of the case to face and run along the pair of opposed walls 81; in particular, in one or more preferred embodiments, such as the one illustrated, each series of heaters 3 follows a line M matching a contour of the respective facing wall 81 along the reference axis Y. Preferably, the heaters 3 of each series are equally spaced from one another.

In one or more embodiments, such as the one illustrated, each series, 3A or 3B, extends approximately from the start of the upstream-end portion 81C of the respective wall 81 to the end of its central portion 81D.

Therefore, the heaters 3 are arranged to heat mainly and predominantly the inlet and central sections 8C, 8D of the case 8.

Preferably, the heating system is configured to heat the inlet section 8C to a higher temperature than the central section 8D.

To this purpose, in one or more preferred embodiments, such as the one illustrated, each series of heaters 3 has an additional heater 3' in the region of the inlet section 8D, which is arranged behind the line M (i.e. further away from the case 8 than the line M) and preferably at an intermediate position between one heater 3 and the following one in the series.

In this way, the heating system is able to determine a steeper increase of the temperature of the process gas flowing through the inlet section 8C of the case 8.

The delivering unit 4 and the exhaust gas extraction unit 6 are both arranged outside of the case 8 and are fluidly connected to the latter (as it will be described in more details below) so that the process gas ejected by the delivering unit 4 can reach the inlet 8A of the case 8, and the process exhaust gas flowing out of the case 8, via the outlet 8B, can reach the extraction unit 6.

In one or more preferred embodiments, such as the one illustrated (see figures 1 to 3), the apparatus 10 comprises a fixed base 12 supporting the case 8, the delivering unit 4 and the exhaust gas extraction unit 6.

The base 12 comprises a plate 12A, for example made of steel, which has a first seat 12B for receiving the delivering unit 4, and a second seat 12C for receiving the exhaust gas extraction unit 6.

A thermally-insulating block 12D is arranged on the plate 12A, between the first and the second seats 12B, 12C, and is configured to receive the case 8 on itself separating it from the plate 12A. Preferably, the thermally-insulating block 12D is made of foam, even more preferably graphite foam.

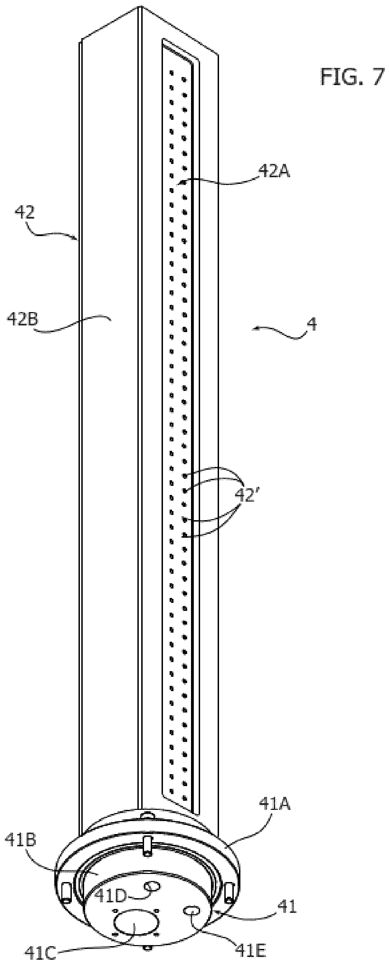

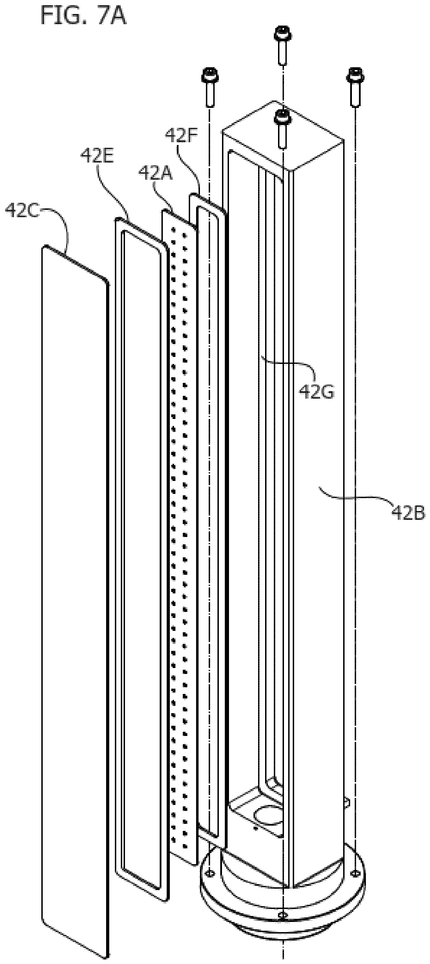

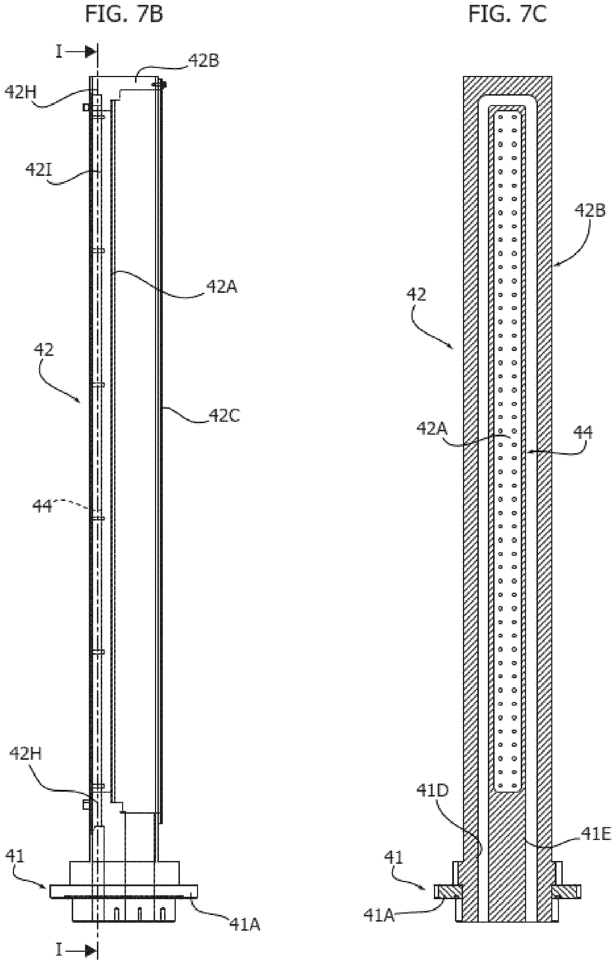

In one or more preferred embodiments, such as the one illustrated (see figures 7, 7A, 7B and 7C), the delivering unit 4 is provided with an inner cooling pipe 44 (see figure 7C) for cooling the process gas before it is ejected by delivering unit. The cooling pipe 44 is connected to a system for heat-conditioning a cooling medium (e.g. water) and making it circulate through the cooling pipe 44.

The cooling action exerted by the cooling medium circulating through the cooling pipe 44 has the function of maintaining the temperature of process gas below a predefined threshold until it reaches the case 8, so as to avoid that reactions of the process gas are prematurely activated. This prevents the process gas from being consumed prematurely and thus wasted, and also prevents the risk of clogging of the delivering unit 4 by particulates that are generated as a result of the reaction of the process gas.

In one or more preferred embodiments, such as the one illustrated (see figures 7, 7A, 7B and 7C), the delivering unit 4 comprises a delivering pylon 42, which is provided with a connection portion 41 at its lower end.

The connection portion 41 is received in the seat 12B of the plate 12A, and is provided with an outer flange 41A for fixing the delivering unit to the plate 12A, e.g., by screws.

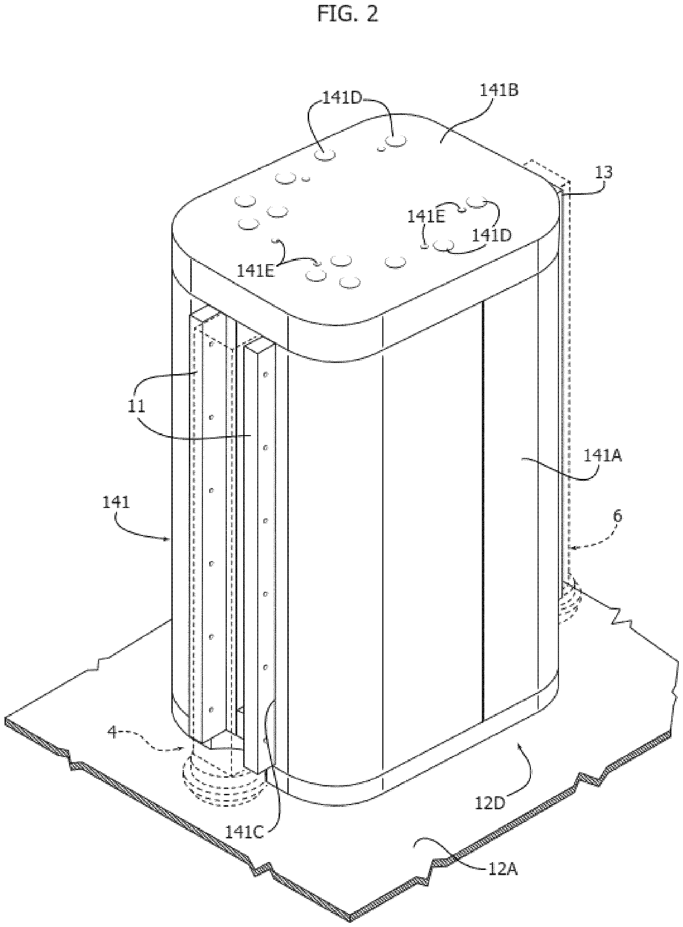

Moreover, the delivering pylon 42 is received in the space between a pair of opposed posts 11 (see figures 2 and 3) fixed to the thermally insulating block 12D of the base 12 and extending parallel to the reference axis Z; the delivering pylon 42 is fixed to the two posts 11, e.g., by screws.

The connection portion 41 has an inlet 41C through which the process gas enters the delivering unit 4, and, also, an inlet 41D and an outlet 41E forming part of the cooling pipe 44 provided within the delivering unit 4.

The inlet 41C is fluidly connected to a supply of the process gas. On the other hand, the inlet 41D and the outlet 41E are connected to the above-said system for the heat-conditioning and circulation of a cooling medium.

With reference to figures 3, 7, 7A, 7B and 7C, the delivering pylon 42 has a closed housing 42B which extends parallel to the reference axis Z, starting from the connection portion 41, and is internally in fluid communication with the inlet 41C of the latter.

The housing 42B comprises one side delimited by a baffle plate 42A and directed towards the inlet 8A of the case 8.

The baffle plate 42A has a plurality of orifices 42' through which the process gas supplied to the delivering unit 4 via the inlet duct 41C is ejected out of the delivering unit towards the inlet 8A of the case 8.

The above-cited plurality of orifices 42' are made in the baffle plate 42A approximately all over its extension area.

The baffle plate 42A has dimensions, along the reference axis Z and the direction orthogonal thereto, that are approximately equal to the corresponding dimensions of the inlet 8A.

In one or more preferred embodiments, such as the one illustrated, the delivering pylon 42 further comprises an inner baffle plate 42A' which is adjacent and parallel to the baffle plate 42A.

The inner baffle plate 42A' preferably has a larger width (along the direction orthogonal to the reference axis Z) than the baffle plate 42A, and has a plurality of orifices that are positioned according to a staggered arrangement with respect to the orifices of the baffle plate 42A.

The side of the housing 42B opposite to the baffle plate 42A is closed by a cover 42C; in order to avoid leaks of the process gas, a first seal 42D is mounted between the cover 42C and the inner baffle plate 42A', a second seal 42E is mounted between the inner baffle plate 42A' and the baffle plate 42A, and a third seal 42F is mounted between the baffle plate 42A and a perimetral edge 42G of the housing 42B.

In one or more preferred embodiments, such as the one illustrated (see figures 7, 7A, 7B and 7C), the baffle plate 42A is arranged at a position displaced inwardly with respect to an end portion 42H of the housing 42B that is located on the same side of the housing 42B as the baffle plate 42A and surrounds the latter.

The end portion 42H projects beyond the baffle plate 42A in the direction towards the case 8 and forms a central conduit section 421 which is traversed by the process gas flowing out from the inside of the housing 42B via the baffle plate 42A.

In one or more preferred embodiments, such as the one illustrated (see figures 7, 7A, 7B and 7C), the cooling pipe 44 is realized as a cavity made in the walls of the housing 42B and of the connection portion 41.

In one or more preferred embodiments, such as the one illustrated (see figures 7, 7A, 7B and 7C), the cooling pipe 44 is made in the end portion 42H of the housing 42B and is arranged to surround the conduit section 42I, running along a trajectory that is contained in a plane parallel to the baffle plate 42A and follows the contour of the latter, specifically its two vertical segments and its upper horizontal segment.

In view of the above, it can be noted that such an arrangement of the cooling pipe 44 enables to have the cooling medium performing its cooling action where the flow of the process gas is already exposed to the heated case 8 and so is the delivering unit 4. In this way, the cooling action performed by the cooling medium explicates maximum efficacy on maintaining the temperature of process gas below a predefined threshold, and also protects the delivering unit 4 from the high temperatures of the heated case 8.

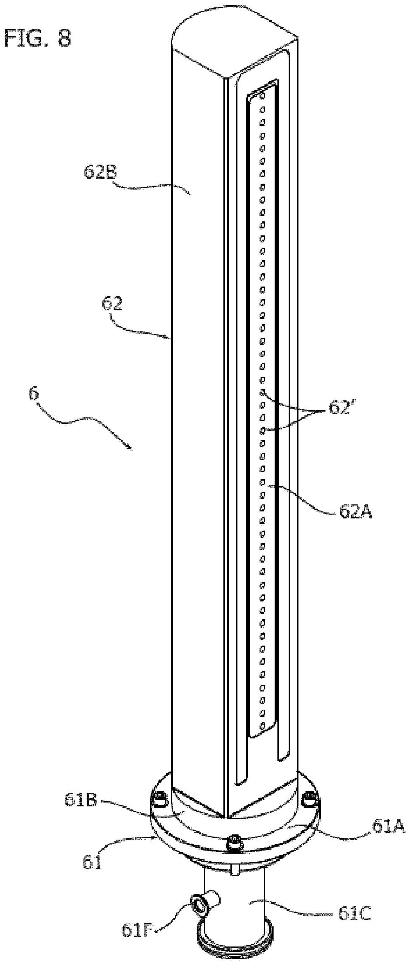

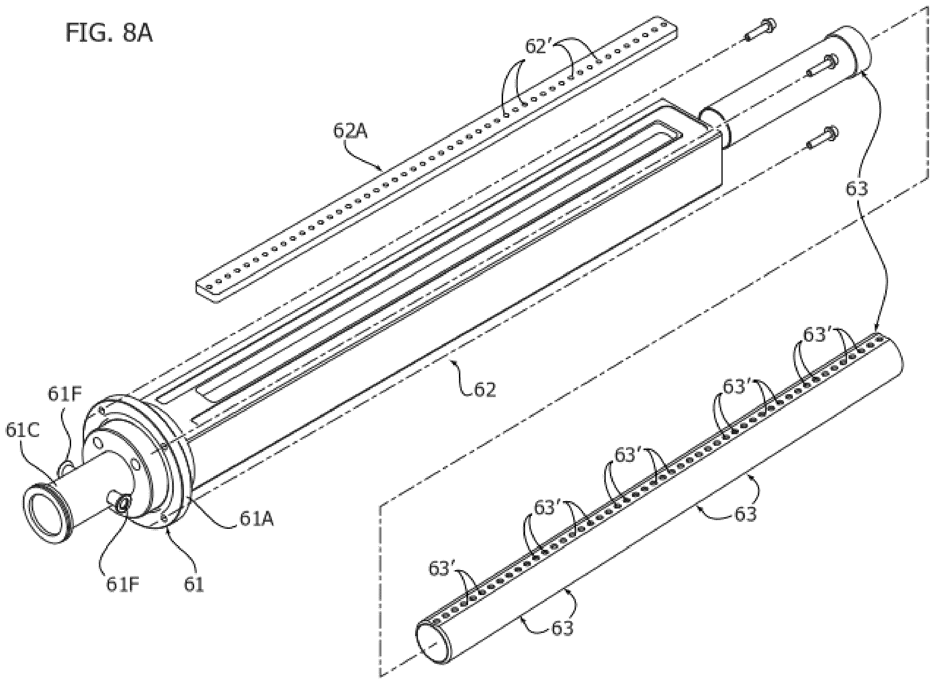

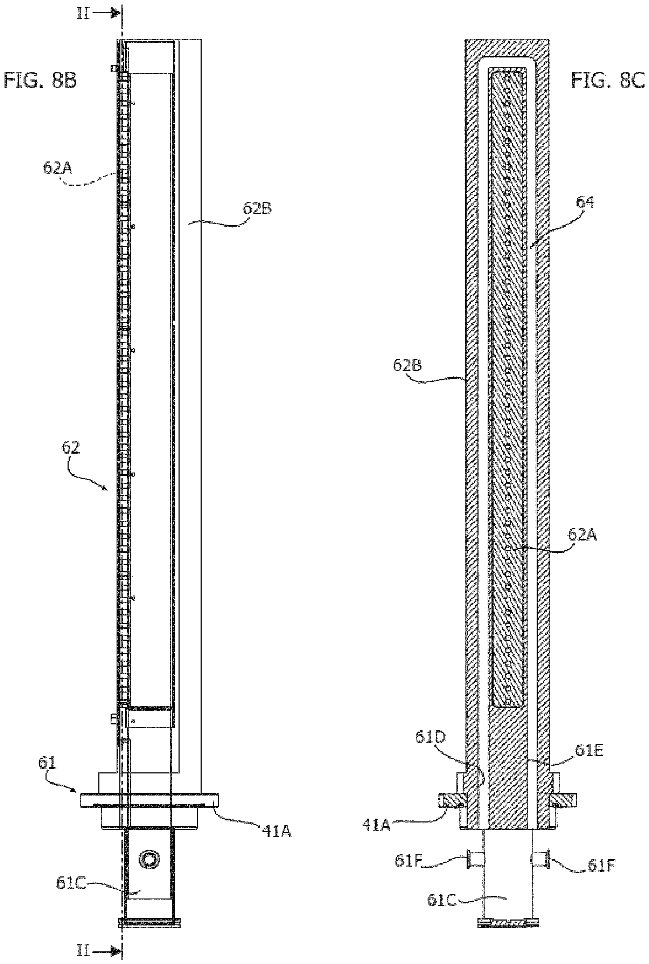

Similarly to the delivering unit 4, in one or more preferred embodiments, such as the one illustrated (see figures 3, 8, 8A, 8B and 8C), the exhaust gas extraction unit 6 is provided with a cooling pipe 64 for cooling the process exhaust gas received from the case 8. The cooling pipe 64 is connected to a system for heat-conditioning a cooling medium (e.g. water) and making it circulate through the cooling pipe 44.

The cooling action operated by the cooling medium circulating through the cooling pipe 64 has the function of making the temperature of the exhaust gas decrease below a predefined threshold in order to prevent possible process gas residuals in the exhaust gas from starting a process reaction and generating particulates that might lead to clogging of the extraction unit.

In one or more preferred embodiments, such as the one illustrated (see figures 3, 8, 8A, 8B and 8C), the exhaust gas extraction unit 6 comprises an extraction pylon 62, which is provided with a connection portion 61 at its lower end.

The connection portion 61 is received in the seat 12C of the plate 12A, and is provided with an outer flange 61A for fixing the extraction unit 6 to the plate 12A, e.g., by screws.

On the other hand, the extraction pylon 62 is received in the space between a pair of opposed posts 13 (see figures 2 and 3) fixed to the thermally-insulating block 12D of the base 12 and extending parallel to the reference axis Z; the extraction pylon 62 is fixed to the two posts 13, e.g., by screws.

The connection portion 61 has an outlet tube 61C through which the exhaust gas suctioned by the extraction pylon 62 flows out of the extraction unit 6, and has, also, an inlet 61D and an outlet 61E forming part of the cooling pipe 64 provided within the extraction unit 6. The inlet 61D and the outlet 61E are connected to the above-said system for the heat-conditioning and circulation of a cooling medium.

In one or more preferred embodiments, such as the one illustrated, the extraction pylon 62 has a closed housing 62B which extends parallel to the reference axis Z and is internally in fluid communication with the outlet duct 62C of the connection portion 61.

In one or more preferred embodiments, such as the one illustrated, the housing 62B comprises one side delimited by a baffle plate 62A and directed towards the outlet 8B of the case 8.

The baffle plate 62A has a single row of orifices 62' running parallel to the reference axis Z, through which the process exhaust gas coming from the outlet 8B is suctioned into the extraction unit 6.

Preferably, the baffle plate 62A extends parallel to the reference axis Z for a length approximately equal to the dimension of the outlet 8B along the reference axis Z.

In one or more preferred embodiments, such as the one illustrated, the extraction pylon 62 and the outlet tube 61C both have inner liners 63 (see Figure 8A) made of a material resistant to high temperatures, only with which the process exhaust gas comes into contact and which are intended to protect the other parts of the extraction pylon 62 and of the vessel body 61B from the high temperatures of the exhaust gas. Preferably, the inner liners are made of graphite. The liners 63 contained in the housing 62B have respective row of bores 63' to be aligned with the row of orifices 62' of the baffle plate 62A.

In one or more preferred embodiments, such as the one illustrated (see figures 8A and 8C), the cooling pipe 64 is realized as a cavity made in the walls of the housing 62B and is arranged to surround the baffle plate 62A, running along a trajectory that is contained in a plane parallel to the baffle plate 42A and follows the contour of the latter, specifically its two vertical segments and its upper horizontal segment.

In view of the above, it can be noted that such an arrangement of the cooling pipe 64 enables to concentrate the cooling action of the cooling medium to the region of the extraction unit 6 where the latter is exposed to the heated case 8. In this way, the exhaust gas is cooled immediately as soon as it enters the extraction unit 6, and the latter is effectively protected from the high temperatures of the heated case 8.

In one or more preferred embodiments, such as the one illustrated (see figure 3), the apparatus 10, further, comprises intermediate duct sections 15, 16 which are positioned, respectively, between the inlet 8A of the case 8 and the delivering pylon 42, and between the outlet 8B of the case 8 and the extraction pylon 62, and which fluidly connect the delivering pylon 42 to the inlet 8A and the extraction pylon 62 to the outlet 8B, respectively.

In this way, the duct sections 15, 16 spatially separate the two pylons 42, 62 from the case 8 and thus create corresponding transition regions whereby a temperature gradient is established in the gas flow and the two pylons 42, 62 then come to be subjected to a gas flow at lower temperatures. The two sections 15, 16 are preferably both made of a material resistant to high temperatures, e.g., graphite.

In one or more preferred embodiments, such as the one illustrated (see figures 1 to 3), the apparatus 10 comprises a housing structure 14, which is movable along the reference axis Z, with respect to the base 12, between a first position (shown in figure 1), in which the housing structure 14 and the base are coupled together and separate the case 8 from the outside, and a second position (shown in figure 3), in which the housing structure 14 is detached from the base 12 and the case 8 can be accessed from the outside.

With reference to figure 1, the apparatus 10 comprises a driving system for moving the housing structure 14 between the first and second positions indicated above.

The driving system can comprise conventional means adapted to realize the indicated movement of the housing structure 14.

In the illustrated example, the apparatus 10 comprises two pairs of driving units 20 which are arranged at two opposite sides of the housing structure 14 and support the latter. Each driving unit 20 comprises a pair of guides 22 parallel to the reference axis Z and a slider 24 to which the housing structure 14 is connected. Furthermore, each driving unit 20 comprises a shaft 26 parallel to the reference axis Z, which is rotationally driven by a motor 27 and which engages an internally-threaded bore of the slider 24 so that a rotation of the shaft 26 determines a corresponding movement of the slider along the reference axis Z.

In operation, the four driving units 20 are synchronically controlled so as to drive together the movement of the housing structure 14 along the reference axis Z.

In one or more preferred embodiments, such as the one illustrated (see figures 2 and 3), the housing structure 14 comprises an inner housing 141 made of a thermally-insulating material. Preferably, the inner housing 141 is made of foam, even more preferably graphite foam.

In one or more preferred embodiments, such as the one illustrated, the inner housing 141 comprises a lateral wall 141A extending around the reference axis Z and a cover 141B placed on top of the lateral wall 141A.

The lateral wall 141A includes two opposite openings 141C, 141D running parallel to the reference axis Z.

In the above-cited first position of the housing structure 14, the inner housing 141 is placed with its lateral wall 141A resting on the block 12D of the base 12 and to receive the case 8 and the intermediate ducts 15, 16 internally. At the same time, the openings 141C, 141D receive, respectively, the posts 11 with the associated pylon 42 and the posts 13 with the associated pylon 62, according to a shape coupling such that each opening finds itself closed with respect to the outside by the respective posts and pylon.

In one or more preferred embodiments, such as the one illustrated (see figure 3), the housing structure 14 also comprises an outer housing 142 which surrounds the inner housing 141 and carries it. Preferably, the outer housing is made of steel.

The outer housing 142 comprises a closed lateral wall 142A extending around the reference axis Z and a cover 142B placed on top of the closed lateral wall 142. The lateral wall 142A surrounds the lateral wall 141A of the inner housing 141 keeping at a distance so as to create an empty space between the two housings.

In the above cited first position of the housing structure 14, the outer housing 142 is placed with its lateral wall 142A resting on the plate 12A of the base 12, and to receive the portions, projecting out of the inner housing 141, of the posts 11, 13 and pylons 42, 62, within its internal space surrounding the inner housing 141.

The outer housing 142 is configured to close hermetically, with respect to the outside, the inner space it delimits together with the base 12. As will be described in the following, in operation, the outer housing 142 is, in fact, intended to contain a controlled atmosphere of inert gas filling both the inside of the inner housing 141 and the inner space comprised between the outer housing 142 and the inner housing 141.

In one or more preferred embodiments, such as the one illustrated, the above-described heaters 3 of the heating systems are mounted on the cover 142B of the outer housing 142 so as to move together with the housing structure 14, when the latter moves from the first position to the second position, and vice versa.

In particular, the heaters 3 hang to the cover 142B and extend to the inside of the inner housing 141 running parallel to the reference axis Z and passing through apertures 141D made on the cover 141B of the inner housing 141; the heaters 3 are reciprocally arranged according to the two series 3A, 3B described above and so as to find themselves in the above-described relative position with respect to the opposed walls 81 of the case 8, when the housing structure 14 is in its first position.

In one or more preferred embodiments, such as the one illustrated (see figure 3), on the cover 142B of the outer housing 142 are also mounted temperature probes 5 projecting into the inside of the inner housing 141 through corresponding apertures 141E made on its cover 141B.

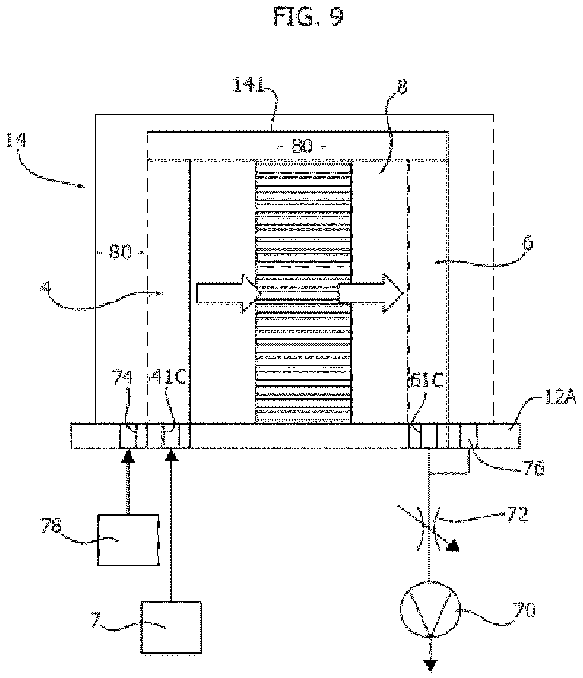

With reference now to figure 9, as anticipated above, the delivering unit 4 is fluidly connected via its inlet 41C to a supply unit 7 for supplying the process gas to the delivering unit 4.

Preferably, the supply unit 7 is configured to supply a predefined flow rate of process gas to the delivering unit 4; for example, the supply unit 7 may include a flow sensor based on which the supply unit 7 regulates the flow rate of the process gas it supplies to the delivering unit 4.

On the other hand, the extraction unit 6 is fluidly connected via its outlet duct 61C to a pump 70 via the interposition of a pressure control valve 72, e.g. a throttle valve. On its turn, the pump 70 is fluidly connected to a system for treating the process exhaust gas. The pump 70 and the pressure control-valve 72 form together an underpressure or vacuum generator apt to determine, in operation, a predefined, minimum pressure in the apparatus. For example, the minimum pressure may range from 10 to 600 mbar.

In one or more preferred embodiments, the apparatus 10 also comprises means for generating a controlled atmosphere 80 inside the housing structure 14.

In particular, in one or more preferred embodiments, such as the one illustrated (see figure 3), plate 12A comprises at least an inlet 74 in fluid communication with the inside of the outer housing 142, more specifically, with the inner space comprised between the outer housing 142 and the inner housing 141.

The inlet 74 is connected to a supply unit 78 which supplies an inert gas, via the inlet 74, to the inside of the housing structure 14 to form and maintain the controlled atmosphere 80 of inert gas inside the housing structure 14. The supply unit 78 may comprise a pressurized tank containing the inert gas, which is associated to a flow control valve for controlling the flow-rate of the inert gas supplied by the pressurized tank.

The inert gas may be a noble gas such as for example helium (He), neon (Ne), argon (Ar), krypton (Kr), or xenon (Xe). Preferably, the noble gas may be argon gas because that is relatively abundant in the atmosphere. Alternatively, the inert gas may be nitrogen. The inert gas may be provided in the pressurized tank of the supply unit 78.

Moreover, plate 12A comprises at least an outlet 76 for the extraction of the inert gas of the controlled atmosphere out of the housing structure 14, which is in fluid communication with the inside of the housing structure 14, more specifically with the inner space comprised between the outer housing 142 and the inner housing 141.

In one or more preferred embodiments, such as the one illustrated, the outlet 76 is fluidly connected to the outlet duct 61C of the extraction unit 6, specifically via a tube fitting 61F provided on the same outlet duct 61C.

In one or more preferred embodiments, such as the one illustrated, the outlet 76 is positioned opposite to the inlet 74, with respect to the inner housing 141; for example, as shown in figures 3 and 9, the inlet 74 can be positioned in proximity to the delivering unit 4, whereas the outlet 76 can be positioned in proximity to the extraction unit 6.

The inert gas flowing into the housing structure 14 via the inlet 74 fills the inner space between the outer housing 142 and the inner housing 141, as well as the space inside the inner housing 141, around the case 8, the inner housing 141 being not hermetically closed.

This means that, in operation, the inner spaces of the two housings 141 and 142 both contain the controlled atmosphere 80 and are at a same pressure.

In view of the above, it can now be noted that the pump 70 operates in cooperation with the throttle valve 72 to establish a predefined, minimum pressure downstream of the extraction unit 6, and that substantially the same pressure is also established for the controlled atmosphere inside the housing structure 14, because of the fluid communication between this latter region and the region downstream of the extraction unit 6.

Conversely, along the flow path through the delivery unit 4, the case 8, and the extraction unit 6 the process gas maintains a higher pressure, due to the pressure differential apt to determine the flow of the process gas along the same path and up to the above-said region downstream of the extraction unit 6.

This means that eventual gas leaks can only occur from the flow path of the process gas to the controlled atmosphere 80, and not vice versa.

The gas leaked to the controlled atmosphere 80 is then removed together with the inert gas via the outlet 76.

On this respect, it is important to note that both the high temperatures and the big temperature ranges the case 8 and the inner housing 141 are subjected to would render it technically very difficult to provide these two structures with a leak-proof hermetic closure. In the solution here described, this problem has been in any case obviated by means of the controlled atmosphere 80 created within the housing structure 14, which operates to contain any possible gas leaks and to purge them via the outlet 76.

To the contrary, the outer housing 142, which has to contain the controlled atmosphere 80, is exposed to lower temperatures than the case 8 and the inner housing 141, and then can be easily provided with an hermetic closure.

Besides solving the problem of the gas leaks, the controlled atmosphere 80 also operates a function of protecting the components of the apparatus from premature deterioration.

Clearly, provided that the principle of the invention is retained, the details of construction and forms of embodiment can be varied, even to a significant degree, from what has been illustrated herein purely by way of non-limiting example, without thereby departing from the scope of the invention, as defined in the attached claims. For example, the apparatus 10 according to the preferred embodiment illustrated in the attached figures can be installed according to a different orientation such that the reference axis Y and the reference axis Z are both horizontal or such that the reference axis Y is vertical and the reference axis Z is horizontal.

## Claims

1. Apparatus (10) for manufacturing semiconductor devices of the type comprising a substrate (101) and a film applied onto the substrate by means of a chemical-vapor-deposition (CVD) process, comprising:
- a process chamber (2) in which to arrange substrates (101) (101') along a first reference axis (Z) in which the substrates (101) lie in parallel planes substantially orthogonal to the first reference axis (Z) ;
- a heating system for heating the process chamber (2) to a predetermined inner temperature;
- a delivering unit (4) for delivering a process gas to the process chamber (2
- an exhaust gas extraction unit (6) for extracting a process exhaust gas from the process chamber (2);
wherein the apparatus comprises a case (8) enclosing the process chamber (2) and having an inlet (8A) receiving the process gas ejected by the delivering unit (4) and an outlet (8B) directing the process exhaust gas towards the exhaust gas extraction unit (6), and wherein the apparatus (10) is configured to build a pressure differential between the inlet (8A) and the outlet (8B) generating a gas flow that traverses the case (8) from the inlet (8A) to the outlet (8B) and across the substrates 101') arranged in the process chamber (2 - a housing structure (14) which is configured to enclose the case (8) and separate it from the outside,
- an inlet (74) and an outlet (76) which are in fluid communication with the inside of the housing structure (14), and
- a supply unit (78) for supplying inert gas, via the inlet (74), to the inside of the housing structure (14) and create a controlled atmosphere (80) of inert gas within the housing structure (14).

2. Apparatus according to claim 1, wherein the case (8) comprises, arranged in succession along the second reference axis:
- an inlet section (8C) including the inlet (8A),
- a central section (8D) enclosing the process chamber (2), and
- an outlet section (8E) including the outlet (2B).

3. Apparatus according to claim 2, wherein the case (8) has a cross sectional flow area that is enlarged at the central section (8D) with respect to the inlet and outlet sections (8C, 8E), such that the gas flow velocity in the central section (8D) is lower than in the inlet and outlet sections (8C, 8E).

4. Apparatus according to claim 2 or 3, wherein the case (8) has a cross-sectional flow area whose dimension along the first reference axis (Z) is uniform and constant all across the inlet, central and outlet sections (8C, 8D, 8E).

5. Apparatus according to any one of the preceding claims, wherein the inlet section (8C) contains a linear series of fins (8F) extending along the first reference axis (Z), the fins facing the inlet (8a) and being equally-spaced along the first reference axis (Z) so as to uniformly distribute the gas flow entering the case inlet (8A) to multiple positions corresponding to the positions of the substrates (101) in the linear formation (101').

6. Apparatus according to any one of the preceding claims, wherein the case (8) comprises a pair of opposed walls (81) both generally extending along the second reference axis (Y) and a pair of end closures (82) which are mounted to edges of the pair of walls (81) that are opposite to one another along the first reference axis (Z) .

7. Apparatus according to claim 6, wherein, with reference to the second reference axis (Y):
each one of the pair of opposed walls (81) has an upstream-end flat portion (81C), a downstream-end flat portion (81E) and a central, concave, cylindrical portion (81D) with a convex side facing to the outside of the case (8); and
each one of the pair of end closures (82) has an upstream-end flat portion (82C), a downstream-end flat portion (82E), and a central flat portion (82D);
wherein the pair of walls (81) and the pair of end closures (82) are assembled together so that:
the upstream-end flat portions (81C) of the pair of opposed walls (81) and the upstream-end flat portions (82C) of the pair of end closures (82) form together an inlet section (8C) of the case (8) including the inlet (8A) ;
the central portions (81D) of the pair of opposed walls (81) and the central portions (82D) of the pair of end closures (82) form together a central section (8D) of the case (8) enclosing the process chamber (2); and
the downstream-end flat portions (81E) of the pair of opposed walls (81) and the downstream-end flat portions (82E) of the pair of end closures (82) form together an outlet section (8E) of the case (8) including the outlet (8B).

8. Apparatus according to any one of the preceding claims, wherein the case (8) is made of a heat conductive material, preferably graphite or silicon carbide, and the heating system is arranged to heat the case.

9. Apparatus according to claim 8, wherein the heating system comprises heaters (3) generating heat radiation to heat up the case (8).

10. Apparatus according to claim 9, wherein the heating system comprises two series (3A, 3B) of heat radiating heaters (3) arranged outside of the case (8) to face and run along a pair of opposed walls (81) of the case (8), the pair of opposed walls (81) generally extending along the second reference axis (Y).

11. Apparatus according claim 10, wherein each series (3A, 3B) of heaters (3) follows a line (M) matching a contour of the respective case wall (81) along the second reference axis (Y).

12. Apparatus according to claim 10 or 11, wherein the heating system is configured to heat the inlet section (8C) of the case (8) to a higher temperature than the central and outlet sections (8D, 8E) of the case (8).

13. Apparatus according to any one of the preceding claims, wherein the delivering unit (4) comprises a baffle plate (42A) having a plurality of orifices through which the process gas is ejected, the baffle plate (42A) being set parallel to the inlet (8A) of the case and orthogonal to the second reference axis (Y).

14. Apparatus according to any one of the preceding claims, wherein the exhaust gas extraction unit (6) comprises a baffle plate (62A) having a plurality of orifices through which the exhaust gas is drawn off, the baffle plate (62A) being set parallel to the outlet (8B) of the case (8) and orthogonal to the second reference axis (Y).

15. Apparatus according to any one of the preceding claims, wherein the delivering unit (4) comprises a cooling pipe for cooling the process gas that is being delivered, and/or wherein the exhaust gas extraction unit (6) comprises a cooling pipe for cooling the process exhaust gas that is being extracted.

16. Apparatus according to any one of the preceding claims, comprising:
- an intermediate duct (15) fluidly connecting the delivering unit (4) to the inlet (8A) of the case (8) while, at the same time, spatially separating the former from the latter, and/or
- an intermediate duct (16) fluidly connecting the exhaust gas extraction unit (6) to the outlet (8B) of the case (8), while, at the same time, spatially separating the former from the latter.

17. Apparatus according to any one of the preceding claims, wherein the first reference axis (Z) is vertical and the second reference axis (Y) is horizontal.

18. Apparatus according to any one of the preceding claims,
wherein the apparatus, further, comprises, an underpressure generator (70, 72) which is fluidly connected to the exhaust gas extraction unit (6) and to the outlet (76), and which is configured to determine, in operation, a predefined minimum pressure in the controlled atmosphere (80) inside the housing structure (14) which is below the pressure of the gas flow traversing the case (8).

19. Apparatus according to claim 18, comprising a base (12) supporting the case (8), the delivering unit (4) and the exhaust gas extraction unit (6);
wherein the housing structure (14) is movable along the first reference axis (Z), with respect to the base (2), between a first position, in which the housing structure (14) and the base (12) are coupled together and separate the case (8) from the outside, and a second position, in which the housing structure (14) is detached from the base (12) and the case (8) can be accessed from the outside.

20. Method for manufacturing semiconductor devices of the type comprising a substrate (101) and a film applied onto the substrate by means of a chemical-vapor-deposition (CVD) process, comprising:
- arranging substrates (101) in a linear formation (101') along a first reference axis (Z) of a process chamber (2) and according to an orientation in which the substrates (101) lie in parallel planes orthogonal to the first reference axis (Z);
- by means of a heating system, heating the process chamber (2) to a predetermined inner temperature;
- by means of a delivering unit (4), delivering a process gas to the process chamber (2),
wherein in the process chamber (2) the process gas undergoes a CVD process to form a film on each substrate (101) of the linear formation (101') and a process exhaust gas is generated;
- by means of an exhaust gas extraction unit (6), extracting the process exhaust gas generated in the process chamber (2);
wherein the method comprises providing a case (8) enclosing the process chamber (2) and having an inlet (2A) receiving the process gas ejected by the delivering unit (4) and an outlet (2B) directing the process exhaust gas towards the exhaust gas extraction unit (6), and generating a gas flow that traverses the case (8) from the inlet (2A) to the outlet (2B) by moving along a second reference axis (Y) transversal to the first reference axis (Z) and across the substrates linear formation (101') arranged in the process chamber (2), and that invests all the substrates (101) arranged in the linear formation (101').
